# EUROPÄISCHE PATENTSCHRIFT

(11) **EP 0 303 161 B1**
(45) Veröffentlichungstag und Bekanntmachung des Hinweises auf die Patenterteilung: **06.04.1994**
(21) Anmeldenummer: 88112559.5
(22) Anmeldetag: 02.08.1988
(51) Int. Cl.: C23C 14/34

(54) **Verfahren zum Aufbringen von Überzügen auf Gegenstände mittels magnetfeldunterstützter Kathodenzerstäubung im Vakuum**
Method for coating objects by means of vacuum sputtering supported by magnetic fields
Procédé pour appliquer des enduits sur des objets par pulvérisation cathodique sous vide assistée par des champs magnétiques

(30) Priorität: 11.08.1987 DE 3726731
(43) Veröffentlichungstag der Anmeldung: 15.02.1989
(73) Patentinhaber: HARTEC GESELLSCHAFT FUR HARTSTOFFE UND DUNNSCHICHTTECHNIK MBH & CO. KG, D-72510 Stetten (DE)
(72) Erfinder: dos Santos Pereira Ribeiro, Carlos A., Dipl-Ing., D-7470 Albstadt 15 (DE)
(74) Vertreter: Vogeser, Werner, Dipl.-Ing.

(56) Entgegenhaltungen:
- EP-A- 0 042 574
- EP-A- 0 121 019
- EP-A- 0 205 028
- WO-A-87/04470
- DD-A- 232 613
- DE-A- 3 331 707
- DE-C-22 725 885

## Beschreibung

Die Erfindung betrifft ein Verfahren zum Aufbringen von Überzügen auf Gegenstände der im Oberbegriff des Anspruchs 1 angegebener Art.

Für die Beschichtung von Gegenständen aller Art stehen heute verschiedene Vakuumbeschichtungsverfahren zur Verfügung. Die eingangs genannte magnetfeldunterstützte Kathodenzerstäubung ist eines dieser Verfahren, das in den letzten Jahren zunehmend an wirtschaftlicher Bedeutung gewonnen hat.

Die am meisten angewandte Variante der Kathodenzerstäubung ist die reaktive Magnetronzerstäubung. Dieses Verfahren wird insbesondere eingesetzt, um Werkstücke mit goldfarbenähnlichen Überzügen aus Titannitrid zu versehen. Die goldähnliche Farbe wird dadurch erreicht, daß die Titan- und Stickstoffanteile der die Überzüge bildenden Verbindungen in einem stöchiometrischen Verhältnis zueinander stehen. Hierfür ist es notwendig, daß der Reaktivgasanteil in der Beschichtungskammeratmosphäre, nämlich der in die Kammer eingeleitete Stickstoff, im Überschuß vorliegt. Mit anderen Worten enthält die Atmosphäre in der Beschichtungskammer zusätzlich zum Edelgas-Partialdruck, der zur Aufrechterhaltung der für die Zerstäubung des Targetmaterials notwendigen Glimmentladung erforderlich ist, auch einen Stickstoffpartialdruck.

Ein ähnliches Verfahren zum Beschichten von Gegenständen mittel Magnetronsputtern mit den Merkmalen gemäß dem Oberbegriff des Anspruchs 1 ist aus der EP-A-0121019 bekannt. Dabei wird zur Aufrechterhaltung der für die Zerstäubung des Targetmaterials notwendigen Glimmentladung ein Edelgas kontinuierlich in die Beschichtungskammer eingeleitet. Mit Hilfe einer Vakuumpumpe wird das Edelgas derart fortlaufend abgepumpt, daß ein konstanter Edelgaspartialdruck in der Beschichtungskammer aufrecht erhalten wird. Weiterhin wird ein Reaktivgas in die Beschichtungskammer eingeleitet, das mit dem zerstäubten Targetmaterial eine Verbindung eingeht, mit der Werkstücke überzogen werden. Die gesamte kontinuierlich in die Beschichtungskammer eingeleitete Reaktivgasmenge ist derart bemessen, daß der Reaktivgasanteil in der Metall-Reaktivgasverbindung des Überzugs im unterstöchiometrischen Verhältnis vorliegt und kein Reaktivgaspartialdruck aufgebaut wird.

Die Reaktivgasströmung wird in der Beschichtungskammer unter Umgehung der Zerstäubungskathode unmittelbar in den Raum zwischen Zerstäubungskathode und der zu beschichtenden Werkstücke geführt.

Nachteilig bei einer derartigen reaktiven Magnetronzerstäubung ist es, daß die Erosionszone der Targetoberfläche mit Verbindungen aus Metall- und Reaktionsgasatomen beschlagen wird, was eine drastische Reduzierung der Zerstäubungsrate zur Folge hat, da diese Verbindungen unter vergleichbaren Prozeßbedingungen eine wesentlich geringere Zerstäubungsausbeute (Anzahl der zerstäubten Metallteilchen je einfallendem Reaktivgasion) erbringen.

Ein weiteres Kathodenzerstäubungsverfahren ist aus der DE-A-3 331 707 bekannt. Bei diesem Verfahren wird das Reaktionsgas in Substratnähe in die Beschichtungskammer eingelassen.

Aus der EP-A 0205028 ist ein Kathodenzerstäubungsverfahren bekannt, bei dem Edel- und Reaktionsgas unmittelbar bei dem Substrat in die Beschichtungskammer eingelassen wird.

Der Erfindung liegt die Aufgabe zugrunde, das eingangs genannte Kathodenzerstäubungsverfahren weiter zu entwickeln und wesentlich zu verbessern, um die Zerstäubungsausbeute und daher auch die Beschichtungsrate gegenüber den Verfahren nach dem Stand der Technik beträchtlich zu erhöhen.

Erfindungsgemäß wird diese Aufgabe bei dem Verfahren nach dem Oberbegriff des Patentanspruchs 1 dadurch gelöst, daß das Reaktivgas in ionisiertem Zustand in die Beschichtungskammer eingeleitet wird.

Durch das erfingungsgemäße Verfahren wird zum einen erreicht, daß die Targeterosionszone, aus der die Metallatome abgestäubt werden, frei von Metall-Reaktivgasverbindungen ist, so daß im Vergleich zu den Verfahren nach dem Stand der Technik, bei denen die Erosionszone der Targetoberfläche mit diesen Verbindungen beschlagen werden, eine wesentlich höhere Zerstäubungsausbeute erzielbar ist.

Zum anderen wird weiterhin ermöglicht, daß der Ionisierungsgrad in der Beschichtungskammer zugunsten einer intensiveren Raumladung erhöht wird, welche die Entstehung der Metall- und Reaktivgasverbindung begünstigt. Ein weiterer Vorteil besteht darin, daß infolge der erhöhten Raumladung die an die Zerstäubungskathode angelegte Spannung ohne Beeinträchtigung der Zerstäubungsausbeute verringert werden kann. Schließlich wird wegen der erhöhten Raumladungsdichte auch die Plasmaentladung an der Targetoberfläche wesentlich stabiler. Das heißt, das mehr oder weniger ausgeprägte Schwingen des Plasmas in Abhängigkeit der Prozeßparameter und der Geometrie der Beschichtungskammer wird weitgehend gedämpft.

Zu der verbesserten Zerstäubungsausbeute trägt entscheidend bei, daß in der Beschichtungskammer kein Reaktivgas-

Partialdruck aufgebaut wird. Mit anderen Worten ließe es sich bei Vorhandensein eines Reaktivgas-Partialdruckes nicht verhindern, daß trotz der erfindungsgemäß gewählten Strömungsführung des Reaktivgases ein gewisser Anteil dieses Gases in den Bereich unmittelbar über die Targetoberfläche gelangt, wo es in Verbindung mit zerstäubtem Metall mit der Folge einer verringerten Zerstäubungsausbeute auf die Erosionszone niedergeschlagen werden würde.

Während mit den Verfahren nach dem Stand der Technik, also bei der Herstellung von stöchiometrischen Metall-Reaktivgasverbindungen, regelmäßig eine Zerstäubungsausbeute von etwa 40 % bezogen auf eine Zerstäubung desselben Targetmaterials bei nicht-reaktiver Prozeßführung erreicht wird, beträgt die mit dem erfindungsgemäßen Verfahren erzielbare, ebenfalls auf eine Zerstäubung bei nicht-reaktiver Prozeßführung bezogene Zerstäubungsausbeute 90 % .

Die Zerstäubungsausbeute bei Anwendung des erfindungsgemäßen Verfahrens ist also um mehr als das Doppelte höher als bei Anwendung der bekannten Verfahren. Berücksichtigt man weiterhin, daß die Reaktivgas- Durchflußmenge bei Aufrechterhaltung des erfindungsgemäß einzustellenden unterstöchiometrischen Verhältnisses in der Metall-Reaktivgasverbindung zugunsten des Metallanteils proportional zur verbesserten Zerstäubungsausbeute erhöhbar ist, so wird klar, daß auch die Beschichtungsrate bei Anwendung des erfindungsgemäßen Verfahrens im Vergleich zu den bekannten Verfahren um mehr als das Doppelte verbessert werden kann.

Ein weiterer Vorteil des erfindungsgemäßen Verfahrens besteht darin, daß die verbesserte Zerstäubungsausbeute bzw. Beschichtungsrate die Keimbildung für das Schichtwachstum an der Werkstückoberfläche wesentlich erhöht. Die erhöhte Schichtwachstumsgeschwindigkeit bewirkt, daß der Schichtaufbau besonders gleichmäßig verläuft, daß also die Schichteigenschaften weitgehend isotrop verteilt sind, wodurch unter anderem vorallem die Eigenspannungen in der auf den Werkstückoberflächen aufgebauten Beschichtungen im Vergleich zu den mit den bekannten Verfahren erreichbaren Schichten wesentlich verringert sind.

Die Leistung der Zerstäubungskathode spielt bei der Herstellung von unterstöchiometrischen Schichten im Sinne des erfindungsgemäßen Verfahrens eine wesentliche Rolle. So können diese Schichten erst dann wirklich zufriedenstellend erzeugt werden, wenn die auf die Targeterosionszone der Zerstäubungskathode bezogene Leistung mindestens 10 Watt/cm² beträgt. Vorteilhafterweise ist diese Leistung jedoch mit mehr als 20 Watt/cm² anzusetzen. Noch bessere Ergebnisse werden mit Leistungen oberhalb von 30 Watt/cm² erzielt.

Auch der Edelgaspartialdruck sollte vorzugsweise im Bereich von 2 bis 5x 10⁻³ mbar, (1 mbar = 100Pa) gewählt werden. Die besten Ergebnisse werden dabei im unteren Druckbereich erzielt, da ein niedrigerer Druck einer größeren mittleren freien Weglänge der Teilchen in der Beschichtungskammer entspricht, was wiederum eine Steigerung der Beschichtungsrate im Verhältnis zur Zerstäubungsrate bewirkt, da die Anzahl der Zusammenstöße zwischen den Partikeln auf dem Weg vom Target zum Werkstück abnimmt. Außerdem wird durch einen möglichst niedrigen Druck die Keimbildung für das Schichtwachstum an der Oberfläche der Werkstücke erhöht.

Vorteilhafterweise wird an die Werkstücke eine negative Vorspannung in der Größenordnung von einigen 50 Volt angelegt. Dadurch wird während des Beschichtungsvorgangs auf der Werkstückoberfläche eine gewisse Zerstäubung der Beschichtung bewirkt, durch die schlecht haftende Partikel wieder von der Werkstückoberfläche abgestäubt werden. Derselbe vorteilhafte Effekt läßt sich auch durch das Anlegen einer hochfrequenten Spannung vergleichbarer Intensität an die Werkstücke erreichen.

Als Targetmaterial für das erfindungsgemäße Verfahren eignet sich sowohl reines Metall wie auch Legierungen aus reinem Metall. So können beispielsweise mit Vorteil Zirkon, Hafnium, Molybdän, Wolfram, Titan ebenso verwendet werden wie Titan-Aluminium-, Titan- Wolfram-, Wolfram- Molybdän- und Chrom-Nickel-Legierungen, beispielsweise zur Herstellung von Titannitrid oder Titankarbid.

Ebenfalls weitgehend frei wählbar sind die für das erfindungsgemäße Verfahren mit Vorteil einsetzbaren Reaktivgase. In Frage kommen Stickstoff, Kohlenstoff, Bor und Silizium enthaltende Gase ebenso wie deren Mischungen sowie Mischungen mit weiteren Gasen, also beispielsweise Stickstoff mit Äthen oder Kohlendioxid, Bor und Äthen und Azethylen und/oder Stickstoff, Silan und Azethylen und/oder Stickstoff.

Die sich daraus unter Anwendung des erfindungsgemäßen Verfahrens ergebenden Überzüge auf den Werkstücken sind dann nahezu unzähliger Art, wie beispielsweise Titan-Aluminium-Oxinitrid, Titan-Wolfram-Silizium-Karbid, Wolfram-Molybdän-Carbonitrid.

Vorteilhafte Anwendungen des erfindunsgemäßen Verfahrens betreffen das Beschichten von Werkzeugen, wie beispielsweise Spiralbohrer, Gewindebohrer, Schneideisen, Fräsern, Wendeschneidplatten, Reibahlen, Stempeln und Matrizen. Durch eine erfindungsgemäße Beschichtung solcher Werkzeuge aus Schnellarbeitsstahl oder aus Hartmetall wird deren Verschleiß- und/oder Korrosionswiderstand wesentlich erhöht.

Ähnliche Vorteile werden auch bei der erfindungsgemäßen Beschichtung von Maschinenteilen erreicht, wie beispielsweise von Fadenführern, Wellen, Zahnrädern, Lagern, Führungsteilen, Spannzangen, Schrauben und Muttern.

Das erfindungsgemäße Verfahren ist aber auch mit Vorteil zur Hartstoffbeschichtung von Gebrauchsgegenständen geeignet, vor allen zur Verbesserung deren Lebensdauer sowie optischen Eigenschaften. Solche Gebrauchsgegenstände sind beispielsweise: Spitzen von Tuschezeichnerröhrchen oder von Kugelschreibern, Schreibgeräte, Uhrengehäuse, Brillengestelle, Armbänder, Türgriffe, Geräte für die chirurgische Medizin sowie Gegenstände aller Art aus Glas, Kunststoff oder keramischen Werkstoffen.

Weitere mit dem erfindungsgemäßen Verfahren erzielbare Vorteile sollen nunmehr anhand der Zeichnung näher erläutert werden.

Die einzige Figur der Zeichnung zeigt ein Diagramm, in dem das Verhältnis zwischen Gesamtgasdruck in der Beschichtungskammer und der Reaktivgas- (hier Stickstoff) Durchflußmenge bei konstantem Edelgas-Partialdruck dargestellt ist.

Die Gerade zwischen den Punkten D und A entspricht dem Edelgas-Partialdruck, der sowohl bei den bekannten Verfahren wie auch beim erfindungsgemäßen Verfahren konstant gehalten wird, bei welchem er dem Gesamtdruck in der Beschichtungskammer entspricht.

Bei der Herstellung von stöchiometrischen Titannitrid-Verbindungen gemäß den Verfahren nach dem Stand der Technik, hat sich der Stickstoff-Partialdruck in der Beschichtungskammer bereits eingestellt, wenn die Zerstäubungskathode in Gang gesetzt wird. Die Größe dieses Partialdrucks entspricht dem Punkt E im Diagramm. Da bei der Herstellung der Titan-Nitrid-Verbindung laufend Stickstoff verbraucht wird, sinkt trotz konstant eingestelltem Stickstoffdurchfluß der Gesamtdruck in der Kammer bis auf den Punkt C. Der Stickstoffpartialdruck in der Kammer entspricht dann der senkrechten Koordinatenkomponente des Abstandes zwischen den Punkten C und D. Die bekannten Verfahren werden mit diesem konstanten Stickstoff-Partialdruck zusätzlich zu dem Edelgas-Partialdruck betrieben.

Bei der Herstellung von unterstöchiometrischen Titannitrid-Verbindungen gemäß dem erfindungsgemäßen Verfahren wird die Zerstäubungskathode zuerst oder gleichzeitig mit dem Stickstoff-Durchfluß eingeschaltet, so daß keine Nitrierung der Targeterosionszone stattfinden kann. Der Stickstoffdurchfluß wird mit niedriger Rate gestartet, anschließend kontinuierlich erhöht und schließlich auf einen Wert zwischen den Punkten D und A eingestellt, deren Verbindungsgerade dem konstanten Edelgas-Partialdruck entspricht, so daß sich in der Atmosphäre in der Beschichtungskammer kein Stickstoffpartialdruck aufbauen kann, obwohl die Stickstoffdurchflußmenge wesentlich größer ist als bei den Verfahren nach dem Stand der Technik.

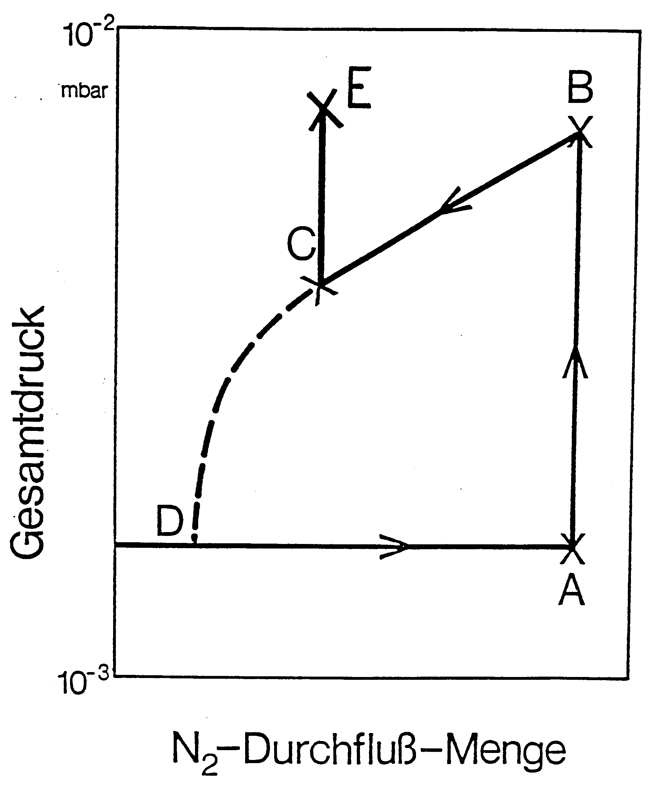

Nachfolgend soll anhand des Diagrammes der Fig.1 beschrieben werden, wie das erfindungsgemäße Verfahren zur Herstellung von Mehrfachschichten, beispielsweise zur Aufbringung einer zusätzlichen Schicht, die Metallanteile im Unterschuß enthält, auf einfache Weise modifiziert werden kann.

Wenn man entgegen den Vorgaben für das erfindungsgemäße Verfahren die Stickstoffdurchflußmenge entweder den Punkt A erreichen läßt oder wenn die Leistung der Zerstäubungskathode verringert wird, was einer Verschiebung der Geraden durch die Punkte A und B im Diagramm nach links in Richtung geringerer Stickstoffdurchflußmenge entspricht, beschlägt die Targeterosionszone mit Titannitrid-Verbindungen. Um diesen Niederschlag auf der Erosionszone zu entfernen, muß die Stickstoffdurchflußmenge verringert werden, bis der Punkt D erreicht wird. Wird die Stickstoffdurchflußmenge hingegen konstant gehalten, so besteht die Atmosphäre in der Beschichtungskammer zusätzlich zum Edelgas-Partialdruck aus einem Stickstoffpartialdruck, entsprechend der Differenz zwischen den Punkten B und A, wodurch überstöchiometrische Titannitrid-Verbindungen mit einem Metallunterschuß erzeugt werden.

Auf diese Weise ist es in einfacher Weise, nämlich ohne Unterbrechung des Beschichtungsprozesses möglich, Mehrfachschichten auf die Werkstücke aufzubringen, die sich durch ihre unterschiedlichen Eigenschaften sinnvoll ergänzen. Beispielsweise kann zur Erfüllung eines funktionellen Zwecks, wie etwa eine Erhöhung des Korrosionswiderstands, eine unterstöchiometrische Schicht, also eine Schicht mit Metallüberschuß auf die Werkstückoberflächen und anschließend eine überstöchiometrische Schicht aufgebracht werden, die Metall im Unterschuß enthält und bessere optische Eigenschaft als die erste Schicht aufweist.

Bei Messungen an den erfindungsgemäß unterstöchiometrisch hergestellten Beschichtungen auf Werkzeugen, also mit Metall im Überschuß, wurde überraschenderweise gefunden, daß die Schichthärte vergleichbar derjenigen von mit den bekannten Verfahren hergestellten stöchiometrischen Beschichtungen ist. Während letztere wegen ihrer relativ geringen Zähigkeit und den auftretenden Schichtspannungen auf Schichtdicken bis zu maximal 3 µm beschränkt sind, können auch Werkstücke mit dem erfindungsgemäßen Verfahren problemlos bis zu Schichtdicken von 6 µm beschichtet werden.

Das erfindungsgemäße Verfahren erlaubt also eine große Variation bei der chemischen Zusammensetzung und der Dicke der Schichten, so daß die Schichteigenschaften optimal an den spezifischen Anwendungsfall angepaßt werden können. Dies ist neben der erhöhten Wirtschaftlichkeit des erfindungsgemäßen Verfahrens einer der bedeutendsten Vorteile gegenüber den bekannten Beschichtungsverfahren.

## Patentansprüche

1. Verfahren zum Aufbringen von Überzügen auf Gegenstände mittels magnetfeldunterstützter Kathodenzerstäubung im Vakuum, bei dem zur Aufrechterhaltung der für die Zerstäubung des Targetmaterials notwendigen Glimmentladung ein Edelgas kontinuierlich in eine Beschichtungskammer eingeleitet und mit Hilfe einer Vakuumpumpe derart fortlaufend abgepumpt wird, daß ein konstanter Edelgas-Partialdruck in der Beschichtungskammer aufrecht erhalten wird, bei dem wenigstens ein Reaktivgas in die Beschichtungskammer eingeleitet wird, das mit dem zerstäubten metallischen Targetmaterial eine Verbindung eingeht, mit der die Werkstücke überzogen werden, wobei die gesamte kontinuierlich in die Beschichtungskammer eingeleitete Reaktivgasmenge derart bemessen ist, daß der Reaktivgasanteil in der Metall-Reaktivgasverbindung des Überzugs im unterstöchiometrischen Verhältnis vorliegt und kein Reaktivgaspartialdruck aufgebaut wird, und bei dem die Reaktivgasströmung in der Beschichtungskammer unter Umgehung der Zerstäubungkathode unmittelbar in den Raum zwischen Zerstäubungskathode und der zu beschichtende Werkstücke geführt wird, **dadurch gekennzeichnet,** daß das Reaktivgas in ionisiertem Zustand in die Beschichtungskammer eingeleitet wird.

2. Verfahren nach Anspruch 1, **dadurch gekennzeichnet,** daß die Zerstäubung des Targetmaterials der Zerstäubungskathode entweder vor oder gleichzeitig mit der Reaktivgaseinleitung begonnen wird, und daß die eingeleitete Reaktivgasmenge langsam auf den bestimmungsgemäßen Endwert erhöht wird.

3. Verfahren nach Anspruch 1 oder 2, **dadurch gekennzeichnet,** daß das Reaktivgas über ein Gasverteilungssystem unmittelbar auf die Werkstückoberflächen geführt wird.

4. Verfahren nach einem der Ansprüche 1 bis 3 , **dadurch gekennzeichnet,** daß die auf die Targeterosionszone bezogene Leistung der Zerstäubungskathode mindestens 10 Watt/cm², vor allem 30 Watt/cm² oder mehr beträgt.

5. Verfahren nach Anspruch 4, **dadurch gekennzeichnet,** daß der den Gesamtdruck in der Beschichtungskammer bildende Edelgas-Partialdruck zwischen 1 und 10 x 10⁻³ mbar, vor allem zwischen 2 und 5 x 10⁻³ mbar beträgt.

6. Verfahren nach Anspruch 4 oder 5, **dadurch gekennzeichnet,** daß an die Werkstücke eine Vorspannung angelegt wird.

7. Verfahren nach Anspruch 6, **dadurch gekennzeichnet,** daß die Vorspannung eine negative Spannung mit einem Betrag von mindestens 50 Volt, vor allem von 100 bis 150 Volt ist.

8. Verfahren nach Anspruch 6, **dadurch gekennzeichnet,** daß die Vorspannung eine hochfrequente Wechselspannung ist.

9. Verfahren nach einem der Ansprüche 1 bis 8, **dadurch gekennzeichnet,** daß das Targetmaterial ein reines Metall, vor allem Zirkon, Hafnium, Molybdän, Wolfram, Titan, oder eine Legierung aus reinen Metallen, vor allem eine Titan-Aluminium-, Titan-Wolfram-, Wolfram-Molybdän- oder eine Chrom-Nickel-Legierung ist, und daß das Reaktivgas ein Gemisch aus Stickstoff, Kohlenstof, Sauerstoff, gasförmigem Bor und/oder Silizium ist.

10. Verfahren nach einem der Ansprüche 1 bis 9, **dadurch gekennzeichnet,** daß nachfolgend auf die Aufbringung eines Überzugs mit einem unterstöchiometrischen Reaktivgasanteil ein weiterer Überzug mit einem überstöchiometrischen Reaktivgasanteil auf die erste Überzugsschicht aufgebracht wird.

11. Herstellung von hartstoffbeschichteten Werkzeugen unter Anwendung des Verfahrens nach einem der Ansprüche 1 bis 10.

12. Herstellung von mit Hartstoffschichten belegten Maschinenteilen unter Anwendung des Verfahrens nach einem der Ansprüche 1 bis 10.

13. Herstellung von mit Hartstoffschichten belegten Gebrauchsgegenständen unter Anwendung des Verfahrens nach einem der Ansprüche 1 bis 10.

## Claims

1. Method for applying coatings to articles by means of magnetic field-assisted cathode sputtering under vacuum, in which, for the purpose of maintaining the glow discharge necessary for the sputtering of the target material, a noble gas is continuously introduced into a coating chamber and is continuously pumped out with the aid of a vacuum pump in such a way that a constant partial pressure of the noble gas is maintained in the coating chamber; in which at least one reactive gas is introduced into the coating chamber and enters into a combination with the sputtered metallic target material, with which combination the work pieces are coated, with the total quantity of reactive gas, which is continuously introduced into the coating chamber, being measured in such a way that the proportion of reactive gas in the metal-reactive gas combination of the coating is present in a sub-stoichiometric ratio and no partial pressure of the reactive gas is built up; and in which the reactive gas flow in the coating chamber, whilst by-passing the sputtering cathode, is conducted directly into the area between sputtering cathode and the work pieces to be coated, characterized in that the reactive gas is introduced into the coating chamber in the ionized state.

2. Method according to claim 1, characterised in that sputtering of the target material of the sputtering cathode is commenced either before, or at the same time as, the introduction of reactive gas and in that the quantity of reactive gas introduced is slowly increased to the prescribed final value.

3. Method according to claim 1 or 2, characterised in that the reactive gas is conducted by way of a gas-distribution system directly onto the work piece surfaces.

4. Method according to one of the claims 1 to 3, characterised in that the rating of the sputtering cathode relative to the target erosion zone amounts to at least 10 watt/cm², in particular 30 watt/cm² or more.

5. Method according to claim 4, characterised in that the noble gas partial pressure which establishes the total pressure in the coating chamber amounts to between 1 and 10 x 10⁻³ mbar, in particular to between 2 and 5 x 10⁻³ mbar.

6. Method according to claim 4 or 5, characterised in that a bias voltage is applied to the work pieces.

7. Method according to claim 6, characterised in that the bias voltage is a negative voltage with a magnitude of at least 50 volts, in particular 100 to 150 volts.

8. Method according to claim 6, characterised in that the bias voltage is a high-frequency alternating voltage.

9. Method according to one of the claims 1 to 8, characterised in that the target material is a pure metal, in particular zirconium, hafnium, molybdenum, tungsten, titanium or an alloy of pure metals, in particular a titanium-aluminium-, titanium-tungsten-, tungsten-molybdenum- or a chromium-nickel-alloy, and in that the reactive gas is a mixture of nitrogen, carbon, oxygen, gaseous boron and/or silicon.

10. Method according to one of the claims 1 to 9, characterised in that, after applying a coating with a sub-stoichiometric proportion of reactive gas, a further coating is applied to the first coating layer with a super-stoichiometric proportion of reactive gas.

11. Production of tools coated with hard materials using the method according to one of the claims 1 to 10.

12. Production of machine parts coated with layers of hard materials using the method according to one of the claims 1 to 10.

13. Production of utility articles coated with layers of hard materials using the method according to one of the claims 1 to 10.

## Revendications

1. Procédé pour appliquer des revêtements sur des objets par pulvérisation cathodique sous vide assistée par champ magnétique,
dans lequel, pour maintenir la décharge électrique nécessaire pour la pulvérisation du matériau cible, un gaz rare est continûment introduit dans une chambre d'enduction et évacué par pompage en continu à l'aide d'une pompe à vide de telle manière qu'une pression partielle en gaz rare constante est maintenue dans la chambre d'enduction,
dans lequel on introduit dans la chambre d'enduction au moins un gaz réactif qui forme une liaison avec le matériau cible métallique pulvérisé dont on recouvre les pièces de travail, où la quantité totale de gaz réactif continûment introduite dans la chambre d'enduction est mesurée de telle manière que la proportion de gaz réactif dans la liaison gaz réactif-métal est inférieure à la proportion stoechiométrique et qu'aucune pression partielle en gaz réactif n'apparaît, et
dans lequel le courant de gaz réactif est dirigé dans la chambre d'enduction par déviation due à la cathode de pulvérisation directement dans l'espace entre la cathode de pulvérisation et les pièces de travail devant être recouvertes,
caractérisé en ce que le gaz réactif est introduit dans la chambre d'enduction à l'état ionisé.

2. Procédé selon la revendication 1, caractérisé en ce que la pulvérisation du matériau cible de la cathode de pulvérisation commence, soit avant, soit en même temps que l'introduction de gaz réactif, et que la quantité de gaz réactif introduite s'élève lentement jusqu'à la valeur finale fixée.

3. Procédé selon la revendication 1 ou 2, caractérisé en ce que le gaz réactif est amené par l'intermédiaire d'un système de distribution des gaz directement sur les surfaces des pièces de travail.

4. Procédé selon l'une des revendications 1 à 3, caractérisé en ce que la cathode de pulvérisation présente une capacité de revêtement de la zone d'érosion cible d'au moins 10 watts/cm², de préférence 30 watts/cm² ou plus.

5. Procédé selon la revendication 4, caractérisé en ce que la pression partielle en gaz rare formant la pression totale dans la chambre d'enduction est comprise entre 1 et 10 x 10⁻³ mbar et est de préférence comprise entre 2 et 5 x 10⁻³ mbar.

6. Procédé selon la revendication 4 ou 5, caractérisé en ce qu'on applique une tension de polarisation aux pièces de travail.

7. Procédé selon la revendication 6, caractérisé en ce que la tension de polarisation est une tension négative d'au moins 50 volts, de préférence de 100 à 150 volts.

8. Procédé selon la revendication 6, caractérisé en ce que la tension de polarisation est une tension alternative à haute fréquence.

9. Procédé selon l'une des revendications 1 à 8, caractérisé en ce que le matériau cible est un métal pur, de préférence du zirconium, du hafnium, du molybdène, du tungstène, du titane, ou un alliage de métaux purs, de préférence un alliage titane-aluminium, titane-tungstène, tungstène-molybdène ou chrome-nickel, et en ce que le gaz réactif est un mélange d'azote, de carbone, d'oxygène, de silicium et/ou de bore gazeux.

10. Procédé selon l'une des revendications 1 à 9, caractérisé en ce que consécutivement à l'application d'un revêtement comportant une proportion de gaz réactif inférieure à la proportion stoechiométrique, on applique sur la première couche de revêtement un revêtement supplémentaire comportant une proportion de gaz réactif supérieure à la proportion stoechiométrique.

11. Fabrication d'outils revêtus d'une matière dure par emploi du procédé selon l'une des revendications 1 à 10.

12. Fabrication de pièces de machines recouvertes de couches de matière dure par emploi du procédé selon l'une des revendications 1 à 10.

13. Fabrication d'objets d'usage courant recouverts de couches de matière dure par emploi du procédé selon l'une des revendications 1 à 10.
